# FASCICULE DE BREVET EUROPEEN

(11) **EP 4 336 552 B1**
(45) Date de publication et mention de la délivrance du brevet: **12.03.2025**
(21) Numéro de dépôt: 23187170.8
(22) Date de dépôt: 24.07.2023
(51) Int. Cl.: H01L 23/427, H01L 23/373

(54) **COMPOSANT ÉLECTRONIQUE COMPRENANT UN FLUIDE DIPHASIQUE POUR ÉVACUER LES CALORIES THERMIQUES DES SEMI-CONDUCTEURS DUDIT COMPOSANT ÉLECTRONIQUE**
ELEKTRONISCHES BAUTEIL MIT ZWEIPHASENFLUID ZUR WÄRMEKALORISCHEN ABFÜHRUNG AUS HALBLEITERN EINES ELEKTRONISCHEN BAUTEILS
ELECTRONIC COMPONENT COMPRISING A TWO-PHASE FLUID FOR REMOVING THERMAL HEAT FROM SEMICONDUCTORS OF SAID ELECTRONIC COMPONENT

(30) Priorité: 12.09.2022 FR 2209135
(43) Date de publication de la demande: 13.03.2024
(73) Titulaire: Airbus (S.A.S.), 31700 Blagnac (FR)
(72) Inventeur: LOEHRMANN, Antoine, 31700 BLAGNAC (FR); CREPEL, Olivier, 31700 BLAGNAC (FR)
(74) Mandataire: Airbus-OPS SAS

(56) Documents cités:
- DE-A1- 102016 218 679
- US-A1- 2019 096 780
- US-A1- 2021 111 098

## Description

### Domaine technique

La présente demande se rapporte à un composant électronique comprenant des moyens de refroidissement direct des semi-conducteurs dudit composant électronique, se présentant sous la forme d'un fluide diphasique circulant au contact desdits semi-conducteurs.

### État de la technique

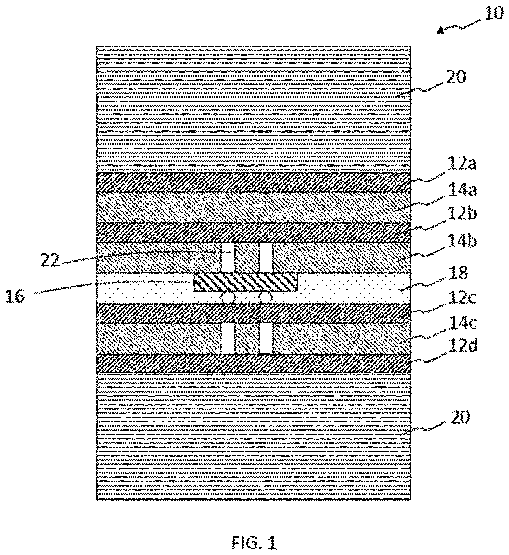

Un composant électronique selon un mode de réalisation est présenté sur la figure 1. Ce composant électronique 10 comporte un empilement de couches de cuivre 12a-d alternées avec des couches d'un substrat en céramique 14a-c. Les couches de cuivre 12a, 12d sont les couches extérieures de l'empilement. Sur une des couches de substrat 14b, est disposé au moins un semi-conducteur 16. Le semi-conducteur 16 est connecté électriquement aux couches de cuivre 12b, 12c adjacentes, via des brasures 22. Le semi-conducteur 16 est protégé par une couche de résine époxy 18, agencée entre la couche de substrat 14b sur laquelle est disposé le semi-conducteur 16 et une couche de cuivre 12c adjacente. Le composant électronique 10 présente une structure connue sous les termes anglo-saxons "Direct Bonded Copper".

Afin de refroidir le semi-conducteur 16, des dissipateurs thermiques 20 sont fixés au composant électronique 10, via une pâte thermique ou directement brasés sur les couches de cuivre extérieures, de part et d'autre de l'empilement de couches . Du fait
de la position des dissipateurs thermiques 20, les pertes thermiques émises par le semi-conducteur 16 doivent être évacuées à travers les couches de cuivre 12a-d et de céramique 14a-c, ce qui engendre des inefficacités puisque lesdites couches présentent une résistance thermique non négligeable.

En outre, de tels dissipateurs thermiques ont un poids non négligeable, qui impacte le poids du composant électronique.

La présente invention vise à proposer une solution alternative à ce mode de refroidissement des semi-conducteurs des composants électroniques.

US2019/096780 A1 divulgue un composant électronique refroidi par un fluide diphasique.

### Résumé de l'invention

A cet effet, l'invention a pour objet un composant électronique comprenant un empilement d'au moins des première et deuxième couches de matériau conducteur électrique, alternées avec au moins une troisième couche de matériau non-conducteur électrique, ladite troisième couche étant agencée entre lesdites première et deuxième couches, et comprenant une première face disposée en regard et à distance de la deuxième couche et une deuxième face opposée à la première face disposée en regard et au contact de la première couche, un volume étant défini entre la première face de la troisième couche et la deuxième couche.

Selon l'invention, le composant électronique comprend au moins un semi-conducteur disposé dans ledit volume sur la première face de la troisième couche et des moyens de refroidissement prenant la forme d'un fluide diphasique remplissant ledit volume.

Ainsi, selon le composant électronique selon l'invention est dépourvu de couche de résine époxy, ainsi que de dissipateur thermique.

Avantageusement, le composant électronique selon l'invention a un poids réduit par rapport au composant électronique de l'art antérieur, puisque ledit composant électronique est dépourvu de dissipateurs thermiques, qui ont un impact non négligeable sur le poids dudit composant électronique. En outre, le composant électronique selon l'invention présente des performances améliorées, notamment grâce à un refroidissement plus efficace des semi-conducteurs, ce qui permet un allongement de leur durée de vie, mais aussi un meilleur rendement du composant électronique. Avantageusement, l'installation du composant électronique selon l'invention est plus aisée, puisque moins volumineux.

Selon une autre caractéristique, le fluide diphasique est un fluide diphasique liquide-gazeux. Selon cette caractéristique, le volume présente une entrée et une sortie, le composant électronique comporte un réservoir de fluide diphasique, une pompe connectée fluidiquement entre le réservoir et à l'entrée dudit volume, le fluide diphasique circulant entre l'entrée et la sortie dudit volume, et un condenseur connecté fluidiquement entre la sortie dudit volume et l'entrée du réservoir.

Selon une autre caractéristique, le fluide diphasique liquide-gazeux est compris dans la liste suivante: une huile diélectrique, de l'eau purifiée, du méthanol, de l'acétone, du gaz réfrigérant R1234 et de l'huile FC-7.

Selon un mode de réalisation qui ne fait pas partie de l'invention, le fluide diphasique est un fluide diphasique solide-liquide. Selon ce mode de réalisation qui ne fait pas partie de l'invention, le composant électronique comporte un boîtier encapsulant les première, deuxième et troisième couches, ledit boîtier étant rempli du fluide diphasique et réalisé en matériau conducteur thermique.

Selon ce mode de réalisation qui ne fait pas partie de l'invention, le fluide diphasique solide-liquide est compris dans la liste suivante: de l'acide laurique, du gallium pur et des microcapsules INERTEK.

Selon une autre caractéristique, le composant électronique est un convertisseur de puissance, ou un interrupteur, ou un onduleur, ou un adaptateur de tension, ou un adaptateur de courant. L'invention a également pour objet un système électronique comprenant au moins un composant électronique selon l'invention, ainsi qu'un aéronef comprenant au moins un système électronique selon l'invention.

### Brève description des figures

D'autres caractéristiques et avantages ressortiront de la description de l'invention qui va suivre, description donnée à titre d'exemple uniquement, en regard des dessins annexés parmi lesquels:
la Figure 1 est une vue schématique en coupe d'un composant électronique, qui illustre un mode de réalisation de l'art antérieur,
la Figure 2 est une vue schématique en coupe d'un composant électronique, qui illustre un mode de réalisation de l'invention,
la Figure 3 est une vue schématique en coupe d'un composant électronique, qui illustre un mode de réalisation de l'invention,
la Figure 4 est une vue schématique en coupe d'un composant électronique, qui illustre un mode de réalisation qui ne fait pas partie de l'invention, et
la Figure 5 est une vue schématique en perspective d'un aéronef comprenant un système électronique, lui-même comprenant un composant électronique, qui illustre un mode de réalisation de l'invention.

### Description détaillée

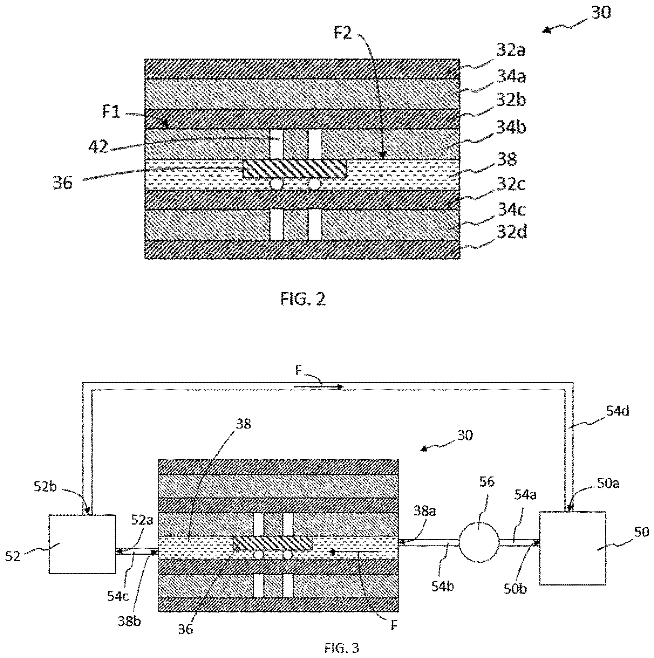

Un composant électronique 30 selon un mode de réalisation de l'invention est représenté sur la figure 2. Ce composant électronique 30 comporte un empilement de couches de matériau conducteur électrique 32a-d, tel que du cuivre, alternées avec des couches de matériau non conducteur électrique 34a-c, par exemple un substrat en céramique. Une première et une quatrième couches de cuivre 32a, 32d sont les couches extérieures de l'empilement. Les couches 34a-34c de céramique sont uniquement des couches intérieures à l'empilement. La première couche 34a de céramique est disposée entre les première et deuxième couches de cuivre 32a, 32b; la deuxième couche 34b de céramique est disposée entre les deuxième et troisième couches de cuivre 32b, 32c; la troisième couche 34c de céramique est disposée entre les troisième et quatrième couches de cuivre 32c, 32d. Bien entendu, le composant électronique 30 peut comprendre plus ou moins de couches 32a-d de cuivre ou de de couches 34a-c de céramique que celles représentées.

Entre la deuxième couche 34b de céramique et la troisième couche 32c de cuivre, un volume 38 est défini. La deuxième couche 34b de céramique présente une première face F1 disposée en regard et au contact de la deuxième couche 32b de cuivre, et une deuxième face F2 opposée disposée en regard et à distance de la troisième couche 32c de cuivre. Autrement dit, les couches 32a, 34a, 32b, 34b sont empilées au contact les unes sur les autres, dans cet ordre, sans espace entre lesdites couches, et les couches 32c, 34c, 32d sont empilées au contact les unes sur les autres, dans cet ordre, sans espace entre lesdites couches, tandis qu'un espace est présent entre les couches 34b et 32c.

Sur la couche 34b de céramique, au niveau de la deuxième face F2, est disposé au moins un semi-conducteur 36. Le semi-conducteur 36 est ainsi disposé dans le volume 38. Le semi-conducteur 36 est connecté électriquement aux deuxième et troisième couches de cuivre 32b, 32c, via des brasures 42. Le composant électronique 30 présente ainsi une structure connue sous les termes anglo-saxons "Direct Bonded Copper".

Le volume 38 de ce composant électronique 30 est dépourvu de résine époxy.

Le composant électronique 30 comprend des moyens de refroidissement agencés au moins en partie dans le volume 38. Ces moyens de refroidissement prennent la forme d'un fluide diphasique qui remplit le volume 38. Autrement dit, le semi-conducteur 36 baigne dans le fluide diphasique qui remplit le volume 38. A l'exception de la surface du semi-conducteur 36 qui est brasée sur la couche 34b de céramique, les autres surfaces du semi-conducteur 36 sont au contact du fluide diphasique. Le fluide diphasique est disposé dans le volume 38, en lieu et place de la résine époxy utilisée selon l'art antérieur représenté sur la figure 1.

Un fluide diphasique est un matériau à changement de phase, qui en fonction de la température, peut changer d'une phase dans un premier état à une phase dans un second état, et inversement. Par exemple, le fluide diphasique peut être un fluide diphasique liquide-gazeux, ou un fluide diphasique solide-liquide.

Ce composant électronique 30 est dépourvu de dissipateur thermique.

Selon le mode de réalisation représenté sur la figure 3, le fluide diphasique est un fluide diphasique liquide-gazeux. De façon non limitative, le fluide diphasique liquide-gazeux peut être une huile diélectrique, de type HFE-7000 (Hydrofluoroether) ou NOVEC^{™} 7000, de l'eau purifiée, du méthanol, de l'acétone, du gaz réfrigérant R1234, ou encore de l'huile FC-7X. Le fluide diphasique est configuré pour être dans une phase liquide lorsque la température est inférieure à une température de changement de phase prédéterminée, et pour passer dans une phase gazeuse lorsque la température devient supérieure à la température de changement de phase prédéterminée. Lorsque le fluide diphasique est en phase gazeuse, ce fluide diphasique est configuré pour repasser en phase liquide lorsque la température redevient inférieure à la température de changement de phase prédéterminée.

Le composant électronique 30 comporte un réservoir 50 de fluide diphasique comprenant une entrée 50a et une sortie 50b. Dans le réservoir 50, le fluide diphasique est dans son état liquide. La sortie 50b du réservoir 50 est connectée fluidiquement à une pompe 56, via une canalisation 54a. La pompe 56 est également fluidiquement connectée à une entrée 38a du volume 38, via une canalisation 54b. Le fluide diphasique circule entre l'entrée 38a et une sortie 38b du volume 38. La pompe 56 permet de mettre sous pression le fluide diphasique issu du réservoir 50, pour que le fluide diphasique soit envoyé et circule correctement dans le volume 38. La circulation du fluide diphasique est représentée par les flèches F. Le composant électronique 30 comporte un condenseur 52 connecté fluidiquement à la sortie 38b du volume 38 et à l'entrée 50a du réservoir 50, respectivement via des canalisations 54c, 54d.

Lors de l'utilisation du composant électronique 30, la température du semi-conducteur 36 augmente, et le fluide diphasique circulant entre l'entrée 38a et la sortie 38b du volume 38 va passer de sa phase liquide à sa phase gazeuse afin d'absorber cette hausse de température et refroidir ledit semi-conducteur 36. Plus précisément, le changement de phase du fluide diphasique permet d'extraire les calories thermiques émises par le semi-conducteur 36 en fonctionnement.

Lorsque le fluide diphasique sous forme gazeuse passe dans le condenseur 52, ce dernier passe de son état gazeux à l'état liquide, avant d'être renvoyé dans le réservoir 50. Le condenseur 52 permet ainsi de refroidir le fluide diphasique, qui a absorbé les calories thermiques du semi-conducteur 36.

Afin de refroidir le fluide diphasique, le condenseur 52 peut être au contact de l'air ambiant, ou au contact d'une boucle de refroidissement secondaire.

Le fait d'utiliser un refroidissement par changement de phase du fluide diphasique permet, en contrôlant la pression à la sortie 38b du volume 38 du composant électronique 30, d'imposer la température de jonction du semi-conducteur 36.

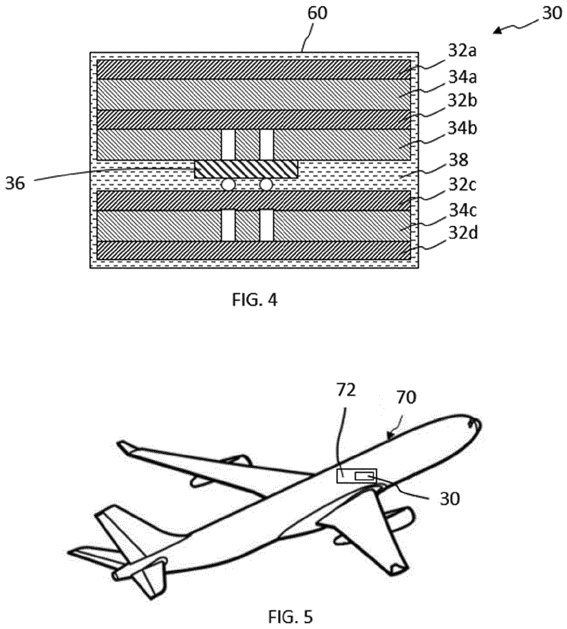

Selon le mode de réalisation représenté sur la figure 4, qui ne fait pas partie de l'invention, le fluide diphasique est un fluide diphasique solide-liquide. De façon non limitative, le fluide diphasique solide-liquide peut être de l'acide laurique, tel que de l'huile de coco (température de changement de phase aux alentours de 25°C), du gallium pur (température de changement de phase aux alentours de 30°C), ou encore des microcapsules INERTEK (température de changement de phase allant de 5°C à 28°C en fonction du matériau à changement de phase microencapsulé). Le fluide diphasique est configuré pour être dans une phase solide lorsque la température est inférieure à une température de changement de phase prédéterminée, et pour passer dans une phase liquide lorsque la température devient supérieure à la température de changement de phase prédéterminée. Lorsque le fluide diphasique est en phase liquide, ce fluide diphasique est configuré pour repasser en phase solide lorsque la température redevient inférieure à la température de changement de phase prédéterminée.

Le composant électronique 30 comporte un boîtier 60 encapsulant les couches 32a-d de cuivre et les couches 34a-c de céramique. Le boîtier 60, et notamment le volume 38 entre la deuxième couche 34b de céramique et la troisième couche 32c de cuivre, autour du semi-conducteur 36, est rempli de fluide diphasique. Dans le boîtier 60, le fluide diphasique est dans son état solide. En phase solide, le fluide diphasique assure une fonction d'immobilisation et de protection du semi-conducteur 36. Le boîtier 60 est réalisé en matériau conducteur thermique, par exemple en aluminium ou en cuivre.

Lors de l'utilisation du composant électronique 30, la température du semi-conducteur 36 augmente, et le fluide diphasique présent dans le volume 38 va passer de sa phase solide à sa phase liquide afin d'extraire les calories thermiques émises par le semi-conducteur 36 en fonctionnement et d'absorber cette hausse de température. Ensuite, le boîtier 60 est configuré pour dissiper thermiquement les calories absorbées par le fluide diphasique lors du changement de phase. Les calories thermiques sont alors évacuées par conduction dans le boîtier 60, puis par convection naturelle ou radiation du boîtier 60 dans l'environnement du composant électronique 30.

La figure 5 représente un aéronef 70 dans lequel est intégré au moins un système électronique 72 comprenant au moins un composant électronique 30 tel que décrit ci-dessus.

Le composant électronique 30 peut être, de façon non limitative, un convertisseur de puissance, un interrupteur, un onduleur ou un adaptateur de tension ou de courant, et plus généralement tout composant électronique comprenant au moins un semi-conducteur dit de puissance.

## Revendications

1. Composant électronique (30) comprenant un empilement d'au moins des première et deuxième couches (32a-d) de matériau conducteur électrique, alternées avec au moins une troisième couche (34a-c) de matériau non-conducteur électrique, ladite troisième couche (34a-c) étant agencée entre lesdites première et deuxième couches (32a-d), et comprenant une première face (F2) disposée en regard et à distance de la deuxième couche (32c-d) et une deuxième face (F1) opposée à la première face (F2) disposée en regard et au contact de la première couche (32a-b), un volume (38) étant défini entre la première face (F2) de la troisième couche (34a-c) et la deuxième couche (32a-d), ledit composant électronique (30) comprenant au moins un semi-conducteur (36) disposé dans ledit volume (38) sur la première face (F2) de la troisième couche (34a-c), et **caractérisé en ce que** ledit composant électronique (30) comprend des moyens de refroidissement prenant la forme d'un fluide diphasique remplissant ledit volume (38), le fluide diphasique étant un fluide diphasique liquide-gazeux, le volume (38) présentant une entrée (38a) et une sortie (38b), et **en ce que** le composant électronique (30) comporte un réservoir (50) de fluide diphasique, une pompe (56) connectée fluidiquement entre le réservoir (50) et l'entrée (38a) dudit volume (38), le fluide diphasique circulant entre l'entrée (38a) et la sortie (38b) dudit volume (38), et un condenseur (52) connecté fluidiquement entre la sortie (38b) dudit volume (38) et l'entrée (50a) du réservoir (50).

2. Composant électronique (30) selon la revendication 1, **caractérisé en ce que** le fluide diphasique liquide-gazeux est compris dans la liste suivante : une huile diélectrique, de l'eau purifiée, du méthanol, de l'acétone, du gaz réfrigérant R1234, et de l'huile FC-7.

3. Composant électronique (30) selon l'une des revendications précédentes, **caractérisé en ce que** ledit composant électronique (30) est un convertisseur de puissance, ou un interrupteur, ou un onduleur, ou un adaptateur de tension, ou un adaptateur de courant.

4. Système électronique (72) comprenant au moins un composant électronique (30) selon l'une des revendications 1 à 3.

5. Aéronef (70) comprenant au moins un système électronique (72) selon la revendication 4.

## Patentansprüche

1. Elektronisches Bauteil (30), umfassend einen Stapel aus mindestens ersten und zweiten Schichten (32a-d) aus elektrisch leitendem Material, die mit mindestens einer dritten Schicht (34a-c) aus elektrisch nicht leitendem Material abwechseln, wobei die dritte Schicht (34a-c) zwischen den ersten und zweiten Schichten (32a-d) angeordnet ist und eine erste Seite (F2), die gegenüber und beabstandet von der zweiten Schicht (32c-d) angeordnet ist, und eine zu der ersten Seite (F2) entgegengesetzte zweite Seite (F1), die gegenüber und in Kontakt mit der ersten Schicht (32a-b) angeordnet ist, umfasst, wobei ein Volumen (38) zwischen der ersten Seite (F2) der dritten Schicht (34a-c) und der zweiten Schicht (32a-d) definiert wird, wobei das elektronische Bauteil (30) mindestens einen Halbleiter (36) umfasst, der in dem Volumen (38) auf der ersten Seite (F2) der dritten Schicht (34a-c) angeordnet ist, und **dadurch gekennzeichnet, dass** das elektronische Bauteil (30) Kühlmittel umfasst, die die Form eines Zweiphasenfluids annehmen, welches das Volumen (38) ausfüllt, wobei das Zweiphasenfluid ein flüssig-gasförmiges Zweiphasenfluid ist, wobei das Volumen (38) einen Einlass (38a) und einen Auslass (38b) aufweist, und dadurch, dass das elektronische Bauteil (30) einen Behälter (50) für Zweiphasenfluid, eine Pumpe (56), die fluidisch zwischen dem Behälter (50) und dem Einlass (38a) des Volumens (38) angeschlossen ist, wobei das Zweiphasenfluid zwischen dem Einlass (38a) und dem Auslass (38b) des Volumens (38) zirkuliert, und einen Kondensator (52), der fluidisch zwischen dem Auslass (38b) des Volumens (38) und dem Einlass (50a) des Behälters (50) angeschlossen ist, beinhaltet.

2. Elektronisches Bauteil (30) nach Anspruch 1, **dadurch gekennzeichnet, dass** das flüssig-gasförmige Zweiphasenfluid in der folgenden Liste enthalten ist: ein dielektrisches Öl, gereinigtes Wasser, Methanol, Aceton, Kältemittelgas R1234 und Öl FC-7.

3. Elektronisches Bauteil (30) nach einem der vorhergehenden Ansprüche, **dadurch gekennzeichnet, dass** das elektronische Bauteil (30) ein Leistungswandler oder ein Schalter oder ein Wechselrichter oder ein Spannungsadapter oder ein Stromadapter ist.

4. Elektronisches System (72), umfassend mindestens ein elektronisches Bauteil (30) nach einem der Ansprüche 1 bis 3.

5. Flugzeug (70), umfassend mindestens ein elektronisches System (72) nach Anspruch 4.

## Claims

1. Electronic component (30) comprising a stack of at least first and second layers (32a-d) of electrically conductive material, alternating with at least one third layer (34a-c) of electrically non-conductive material, said third layer (34a-c) being positioned between said first and second layers (32a-d), and comprising a first face (F2) arranged facing and at a distance from the second layer (32c-d) and a second face (F1) opposite the first face (F2) arranged facing and in contact with the first layer (32a-b), a volume (38) being defined between the first face (F2) of the third layer (34a-c) and the second layer (32a-d), said electronic component (30) comprising at least one semiconductor (36) arranged in said volume (38) on the first face (F2) of the third layer (34a-c), and **characterized in that** said electronic component (30) comprises cooling means taking the form of a two-phase fluid filling said volume (38), the two-phase fluid being a liquid-gas two-phase fluid, the volume (38) having an inlet (38a) and an outlet (38b), and **in that** the electronic component (30) comprises a tank (50) of two-phase fluid, a pump (56) fluidically connected between the tank (50) and the inlet (38a) of said volume (38), the two-phase fluid flowing between the inlet (38a) and the outlet (38b) of said volume (38), and a condenser (52) fluidically connected between the outlet (38b) of said volume (38) and the inlet (50a) of the tank (50).

2. Electronic component (30) according to Claim 1, **characterized in that** the liquid-gas two-phase fluid is included in the following list: a dielectric oil, purified water, methanol, acetone, R1234 refrigerant gas, and FC-7 oil.

3. Electronic component (30) according to either of the preceding claims, **characterized in that** said electronic component (30) is a power converter, or a switch, or an inverter, or a voltage adapter, or a current adapter.

4. Electronic system (72) comprising at least one electronic component (30) according to one of Claims 1 to 3.

5. Aircraft (70) comprising at least one electronic system (72) according to Claim 4.
